(19) Europäisches Patentamt
European Patent Office
Office européen des brevets

(11) Publication number: **0 378 144 B1**

(12) **EUROPEAN PATENT SPECIFICATION**

(45) Date of publication of patent specification: **08.03.95**

(51) Int. Cl.$^6$: **C08F 220/20**, C09D 4/02, G03C 9/08

(21) Application number: **90100294.9**

(22) Date of filing: **08.01.90**

(54) **Photocurable compositions.**

(30) Priority: **10.01.89 US 295328**
**22.03.89 US 326948**

(43) Date of publication of application:
**18.07.90 Bulletin 90/29**

(45) Publication of the grant of the patent:
**08.03.95 Bulletin 95/10**

(84) Designated Contracting States:
**BE CH DE ES FR GB IT LI NL SE**

(56) References cited:
**EP-A- 0 171 069**
**US-A- 4 789 620**

(73) Proprietor: **CIBA-GEIGY AG**
**Klybeckstrasse 141**
**CH-4002 Basel (CH)**

(72) Inventor: **Hunziker, Max, Dr.**
**Chasseralstrasse 8**
**CH-3186 Düdingen (CH)**
Inventor: **Schulthess, Adrian, Dr.**
**Uf em Bärg**
**CH-1734 Tentlingen (CH)**
Inventor: **Hofmann, Manfred, Dr.**
**Route Bel-Air 38**
**CH-1723 Marly (CH)**
Inventor: **Klingert, Bernd, Dr.**
**Möndenweg 87**
**D-7854 Inzlingen (DE)**
Inventor: **Leyden, Richard Noel**
**22024 Alta Drive**
**Topanga Canyon, CA 90290 (US)**
Inventor: **Schmidt, Kris Alan**
**3615 Gilman Road No. 32**
**El Monte, CA 91732 (US)**
Inventor: **Bernhard, Paul, Dr.**
**Rue Marcello**
**CH-1700 Fribourg (CH)**

(74) Representative: **Zumstein, Fritz, Dr. et al**
**Patentanwälte,**
**Dr. F. Zumstein,**
**Dipl.-Ing. F. Klingseisen,**
**Bräuhausstrasse 4**
**D-80331 München (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.09/3.3.3)

## Description

The present invention relates to liquid resin compositions which are photosensitive, a process for polymerizing said compositions by means of actinic radiation and a process for generating three-dimensional objects from these liquid resin compositions.

It is known to utilize radiation-sensitive liquid resin compositions in many different fields of technology, e.g. in coatings, photoresists, relief printing forms and printing inks or adhesives. Typical examples and design considerations of light curable compositions containing acrylic or vinyl compounds and suitable photoinitiators are described in S.P. Pappas (Ed.), "UV Curing: Science and Technology" published by the Technology Marketing Corp., e.g. pp. 171-184 (1978). In principle such liquid resin compositions are also suitable for the production of three-dimensional solid objects by the stereolithographic process as described in US-A-4,575,330. However the typical systems are appropriate materials for particular applications such as coatings or adhesives but are unsuitable in the stereolithographic process. Many are too viscous, others exhibit unacceptable shrinkage upon curing or insufficient photosensitivity for e.g. laser exposure at a given wavelength. Others produce objects with insufficient strength or exhibit poor layer-to-layer adhesion or brittleness after complete cure.

"Stereolithography" is a method for making solid objects by successively "printing" thin layers of a curable material. e.g. a UV curable material, one on top of the other. A programmed movable spot beam of UV light shining on a surface or layer of UV curable liquid is used to form a solid cross-section of the object at the surface of the liquid. The object is then moved, in a programmed manner, away from the liquid surface by the thickness of one layer, and the next cross-section is then formed and adhered to the immediately preceding layer defining the object. This process is continued until the entire object is formed.

Essentially all types of object forms can be created with the technique of stereolithography. Complex forms are more easily created by using the functions of a computer to help generate the programmed commands and to send the program signals to the stereolithographic object forming subsystem.

Of course, it will be appreciated that other forms of appropriate synergistic stimulation for a curable fluid medium, such as particle bombardment (electron beams and the like), chemical reactions by spraying materials through a mask or by ink jets, or impinging radiation other than ultraviolet light, may be used in the practice of the stereolithographic process.

By way of example, in the practice of stereolithography, a body of a fluid medium capable of solidification in response to prescribed stimulation is first appropriately contained in any suitable vessel to define a designated working surface of the fluid medium at which successive cross-sectional laminae can be generated. Thereafter, an appropriate form of synergistic stimulation, such as a spot of UV light or the like, is applied as a graphic pattern at the specified working surface of the fluid medium to form thin, solid, individual layers at that surface, each layer representing an adjacent cross-section of the three-dimensional object to be produced. Superposition of successive adjacent layers on each other is automatically accomplished, as they are formed, to integrate the layers and define the desired three-dimensional object. In this regard, as the fluid medium cures and solid material forms as a thin lamina at the working surface, a suitable platform to which the first lamina is secured is moved away from the working surface in a programmed manner by any appropriate actuator, typically all under the control of a micro-computer or the like. In this way, the solid material that was initially formed at the working surface is moved away from that surface and new liquid flows into the working surface position. A portion of this new liquid is, in turn, converted to solid material by the programmed UV light spot to define a new lamina, and this new lamina adhesively connects to the material adjacent to it, i.e., the immediately preceding lamina. This process continues until the entire three-dimensional object has been formed. The formed object is then removed from the container and the apparatus is ready to produce another object, either identical to the first object or an entirely new object generated by a computer or the like.

In the last few years different efforts have been made to develop systems which are specifically designed for the stereolithographic process. Kodama, Rev. Sci. Instrum. 52 (11) 1170-1173 (1981) discloses as the liquid photo-hardening polymer the commercial product "Tevista" which is a mixture of unsaturated polyester, acrylic ester, styrene monomer, polymerization initiator and sensitizer. The disadvantage of this system in the stereolithographic process resides in its insufficient photosensitivity and its very low green strength. US-A-4,575,330 describes the stereolithography process in detail and as liquid medium a modified acrylate is reported which is a commercial product of Loctite Ltd. "Potting Compound 363". Such compositions are disclosed in US-A-4,100,141. This type of liquid resin compositions exhibit a insufficient photosensitivity which causes inacceptable build-up times for generating three-dimensional objects. A system which is actually used at present in stereolithography is "Desolite® SLR 800" (ex De Soto Inc.) This type of material containing various difunctional acrylates allows to generate small complex objects within a

reasonable time. The drawbacks of this composition is its only mediocre photosensitivity, the very low green strength, the significant shrinkage upon cure and the brittleness after complete cure.

It is evident that liquid resin compositions suitable in the stereolithographic process must fulfill various requirements placed on them. The difficulty is that the number of parameters is relatively high with the additional complexity that these parameters are not independent from each other in the sense that an improvement with respect to one parameter almost automatically results in a reduced performance in another property. The most important requirements, which a stereolithographic composition should fulfill, are:

(a) The viscosity must be adapted to the apparatus for the production of three-dimensional objects by stereolithography. For the levelling method known at the present time the preferred viscosity range is 1000 to 4000 mPas.

(b) The new technology of stereolithography requires a new definition of photosensitivity describing the relationship between the incident energy and the penetration depth into the liquid photosensitive composition forming solidified portions in this way. This property is known as "working speed". A suitable stereolithographic composition should require minimal exposure energy and exhibit a high cure depth.

(c) In the process of sequential photopolymerization of thin layers usually none of these layers is fully cured. An incomplete cure involves many gains in that it strongly reduces shrinkage (and thus deformation and internal stresses) increases or in some cases even enables layer to layer adhesion and markedly reduces the build-up time. The not fully cured object is called "green part" and the elastic or tensile modulus is known as "green strength". The green part receives a postcure of some sort, usually a suitable irradition such as flood exposure to UV/VIS light e.g. of a mercury or xenon arc lamp. The green strength of a workpiece is a very important parameter, as objects with a low green strength may deform under their own weight when removed from the liquid resin composition or they may sag when heated.

(d) Another important factor in stereolithography is the shrinkage and stress related deformation occurring upon curing which is known as curl. A curl factor of 1 indicates that no deformation is detectable. Usually a composition exhibiting a high cure depth shows an increased curl factor up to 3 or even more. Acceptable curl factors are between 1 and 1.5.

(e) It is evident that the objects produced by the stereolithographic process must exhibit good mechanical properties such as tensile strength, impact resistance and elongation at break. Frequently such parts are subsequently treated by sand blasting, sanding, filing etc. or may be cut or drilled.

From the above it is obvious that the selection of the liquid resin composition is a critical issue. Accordingly it is the object of the present invention to provide improved photopolymerizable compositions, especially for the stereolithographic process exhibiting high green strength in conjunction with a low curl factor and a high working speed: The liquid resin composition is useful in stereolithography, as adhesives or generally in coating processes, e.g. in the curtain coating process. Such compositions are preferably transparent to visible light when cured. The cured materials exhibit high strength and high toughness.

Accordingly, the present invention relates to liquid resin compositions which are photosensitive and have a viscosity in the range of 500 to 5000 mPas at 30 °C comprising

(i) at least one monomeric or oligomeric diacrylate or dimethacrylate having a viscosity of more than 500 mPas at 25 °C

(ii) at least one tri-, tetra- or pentaacrylate or -methacrylate selected from the group consisting of the compounds of the formulae I, II and III

$R^1-CH_2-C-(CH_2-R^2)_3$ (I)

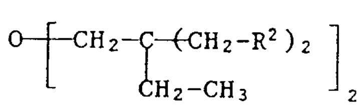

(II)

$R^2-CH-(CH_2-R^2)_2$ (III),

wherein $R^1$ denotes hydrogen, methyl, hydroxy or a group

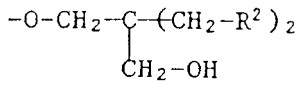

(IV)

and $R^2$ is a group

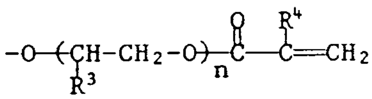

(V)

wherein n is an integer 0, 1, 2 or 3, $R^3$ and $R^4$ are each independently of the other hydrogen or methyl,
(iii) at least one unsaturated monofunctional monomeric compound of the formula VI

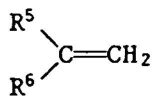

(VI),

wherein $R^5$ denotes hydrogen or methyl and $R^6$ is a group of the formula VII

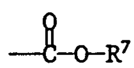

(VII),

$R^7$ being tetrahydrodurfuryl, cyclohexyl, 2-phenoxyethyl, benzyl, isobornyl, glycidyl, dicyclopentenyl, morpholinoethyl, dimethylaminoethyl, diethylaminoethyl or a $C_1$-$C_{20}$ linear or branched aliphatic residue, or - if $R^5$ is hydrogen $R^6$ denotes additionally pyrrolidinon-2-yl, imidazolyl, carbazolyl, anthracenyl, phenyl, $C_5$-$C_8$ cycloalkyl, naphtenyl, 2-norbornyl, pyridyl, N-caprolactamyl or toluyl and
(iv) a photo-polymerization initiator for (i), (ii) and/or (iii).

In a preferred embodiment of the instant invention component (i) contains an acrylic or methacrylic diester of the general formula VIII

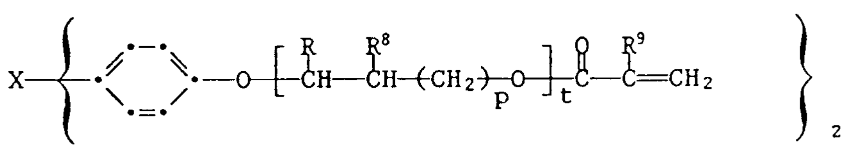

(VIII),

wherein p is 0 or 1 and t is 0 or 1 and if p is 0, t can also be 2 or 3, X denotes -O-, -S-, $-SO_2-$ or $-C(R^{10})(R^{11})-$, $R^{10}$ and $R^{11}$ each being independently of the other hydrogen, $-CF_3$ or methyl and R denotes hydrogen if p is 1 and hydrogen or methyl if p is 0, and $R^8$ denotes hydroxy if p is 1 and hydrogen if p is 0, and $R^9$ is hydrogen or methyl.

Most preferably component (i) contains at least one compound of the formula VIII, wherein p is 1, particularly the bisphenol-A-type materials, wherein X denotes $-C(CH_3)_2-$. Such compounds are known, e.g. from US-A-3,661,576. These compounds can be produced by reacting the corresponding diglycidylethers with acrylic or methacrylic acid and thus contain usually a certain amount of oligomeric materials. If the viscosity of these mixtures is too high the desired viscosity can be adjusted with the components (ii) and/or (iii) having a low viscosity.

The compounds of the formula VIII, wherein p is 0 are also known, e.g. from GB-A-1,263,541 and are usually prepared by a transesterification reaction of the corresponding diols with the methylester of acrylic or methacrylic acid.

In a further preferred embodiment of the instant invention a mixture of compounds of the formula VIII is used, e.g. at least one compound wherein p is 1 and at least one compound wherein p is 0. The ratio between these compounds is not critical, in preferred mixtures the amount of the p = 1-compound is >50 % per weight based on the total weight of the component (i).

Depending on the desired properties of the liquid resin composition and the crosslinked polymer the component (i) is present in a total amount of about 10 to about 80 weight percent based on the total composition, preferably 25 to about 80 weight percent.

If compounds of the formula VIII, wherein p is 1 are used, they are present in a total amount of about 30 to about 60 weight percent based on the total liquid resin composition.

Amongst the compounds of the formula I, II and III those of the formula I wherein $R^1$ is methyl or a group of the formula IV and $R^2$ denotes a group of the formula V wherein n is 0 are particularly preferred.

Especially preferred are trimethylolpropanetrimethacrylate and dipentaerythritolpentaacrylate. Beside these two a large number of tri- or multifunctional monomeric acrylates or methacrylates are known by those skilled in the art. e.g. pentaerythritoltetraacrylate, glyceroltriacrylate or the triacrylate of tris-(hydroxyethyl)-isocyanurate. Many of these compounds are also commercially available. Preferably the component (ii) is present in an amount of about 5 to about 25 weight percent of the total composition. Amounts below this range produce compositions with low rigidity and low green strength. Higher amounts cause higher shrinkage.

Also the monofunctional monomeric compounds of the formula VI are well known compounds many of which are commercially available. Most of them have a low viscosity which allows to adjust the viscosity of the whole system. Examples of such compounds are 1-vinylpyrrolidone, isobornylacrylate and/or phenoxyethylacrylate. Generally compounds of the formula VI having relatively bulky substituents are especially suitable. The residue $R^5$ in formula VI preferably denotes a group of the formula VII. If $R^7$ is a $C_1$-$C_{20}$ linear or branched aliphatic residue it denotes preferably a bulky $C_3$-$C_{12}$alkyl substituent. The most preferred compounds of the formula VI are those which have a boiling point above 140°C and particularly those of the formula VI wherein $R^5$ is hydrogen and $R^6$ is a group of the formula VII, pyrrolidon-2-yl or N-caprolactamyl.

In preferred compositions the component (iii) is present in an amount of about 1 to about 25, and most perferably in an amount of about 5 to about 25 weight percent based on the total composition.

All types of photoinitiators generating free radicals when subjected to radiation are useful as component (iv) of the instant composition. The absorption characteristics must match the spectral features of the radiation source. Typical compounds known as photoinitiators include benzoins or benzoinethers, such as benzoin, benzoinmethylether, benzoinethylether and benzoinisopropylether, benzoinphenylether and benzoinacetate; acetophenones, such as acetophenone, 2,2-dimethoxyacetophenone, and 1,1-dichloroacetophenone; benzil; benzilketales, such as benzildimethylketal, benzildiethylketal; anthraquinones, such as 2-methylanthraquinone, 2-ethylanthraquinone, 2-t.butylanthraquinone, 1-chloroanthraquinone and 2-amylanthraquinone; triphenylphosphine; benzophenones, such as benzophenone and 4,4′-bis-(N,N′-dimethylamino)-benzophenone; thioxanthones and xanthones; acridine derivatives; phenazine derivatives; quinoxaline derivatives or 1-phenyl-1,2-propandione-2-0-benzoyl oxime; 1-aminophenylketones or 1-hydroxyphenylketones, such as 1-hydroxycyclohexyl-phenylketone, phenyl-(1-hydroxyisopropyl)-ketone and 4-isopropyl phenyl-(1-hydroxyisopropyl)-ketone; all of them being known compounds.

Particularly suitable initiators (iv) and usually used in conjunction with a HeCd laser as radiation source are acetophenones, e.g. the 2,2-dialkoxybenzophenones, and the $\alpha$-hydroxy-phenylketones, e.g. 1-hydroxycyclohexyl-phenylketone or (2-hydroxyisopropyl)-phenylketone (=2-hydroxy-2,2-dimethylacetophenon).

Another preferred class of initiators (iv) and usually used in conjunction with an argon-ion laser are the benzilketals, e.g. the benzildimethylketal.

The photoinitiators are known to be added in an effective amount within the range of about 0.1 to about 10 weight percent based on the total composition. If the instant compositions are used in the stereolithographic process normally using a laser light source it is essential that the absorbance of the composition is adjusted by the type and concentration of the initiator to a level allowing a cure depth at practical laser drawing speed of approximately 0.1 to 2.5 mm.

If desired the compositions of the instant invention can optionally contain further customary additives, such as stabilisers and/or polymerization inhibitors, air release agents, wetting and levelling agents, sensitizers and photoactivators, oxygen scavengers, antisettling agents, dyes, pigments or fillers e.g. plastic beads.

The compositions according to this invention can be produced in a known manner, e.g. by a premixing of the individual constituents and the subsequent combining thereof, or by mixing together the individual components in devices normally used for the purpose, such as stirrer vessels, which ensure a uniform mixing, in the absence of light and e.g. at slightly elevated temperatures.

The instant compositions are photosensitive. Suitable radiation sources are useful, e.g. e-beam, X-ray, UV- and VIS-light, having wavelength within the range of 280-650 nm. Particularly useful is laser light from HeCd, argon- or nitrogen-ion, metal vapour and frequency multiplied NdYAG lasers. It is known by the

skilled persons that for each chosen light source the appropriate initiator(s) has to be adapted and/or sensitized. However it has to be recognized that the penetration depth and the working speed directly depend on the absorption coefficient and the concentration of the photoinitiator(s). In stereolithography preferred initiators are those allowing the highest penetration depth combined with the highest number of generated initiating free radicals per energy unit.

The instant compositions are liquids with viscosities in the range of 500 to 5000 mPas at 30 °C, most preferably 1000 to 4000 mPas. One of the unexpected features of these compositions is their high photosensitivity in combination with low curl and high green strength. This excellent combination of properties, being especially important in the stereolithographic process, is not found in known resin systems. A further characteristic of the new photopolymer systems of this invention is their high strength and toughness after complete cure.

Accordingly the instant invention further relates to a method of gene-rating three-dimensional objects from a fluid medium capable of altering its physical state when subjected to prescribed radiation, said method comprising:

- containing as fluid medium a body of a composition according to claim 1;
- irradiating a designated surface of said composition with a prescribed pattern to provide a thin cross-sectional lamina at said designated surface; and
- repeatedly forming a series of such laminae in succession to build the desired three-dimensional object from successive adjacent laminae which together define said object.

The radiation source used in this method is preferably a UV-laser beam which is most preferably computer controlled.

In the technology of coatings the photopolymerizable compositions of the invention produce clear and hard coatings on wood, paper, metal, ceramics and other surfaces. The thickness of accordingly produced coatings may vary in a broad range, e.g. from a few µm to about 1 mm. Relief images for printed circuits or printing plates can be formed by direct imaging of the photocurable compositions of the invention e.g. by a computer controlled laser beam of a suitable wavelength or by proximity printing using masks and a collimated light source.

The following non limiting examples illustrate embodiments of the radiation-polymerizable mixture of the invention and the use thereof in stereolithography.

Viscosity was measured at the specified temperature on a Brookfield Viscosimeter Type LVTDV-II with spindle #62.

Photosensitivity was determined from the "working curve", a curve which was generated by curing a series of lines at various energy levels and plotting cure depth against curing energy. Curing energy is varied by the drawing speed with the laser power constant at approximately 10 mW.

The curl factor as a specific parameter for stereolithography was determined from test specimens having areas which were allowed to freely deform under shrinkage and stress and areas that were braced and supported in order to avoid deformation. The curl factor was calculated from the height of the braced part and the height of the unsupported part. A ratio of 1 indicates that no shrinkage induced deformation occurs, values of up to 1.5 are acceptable.

Mechanical properties of the laser-cured (green strength) and the postcured materials were evaluated from conventional stress-strain curves recorded on an Instron 1112 tensile testing machine equipped with a 20 N force transducer and operating at a constant velocity of 5 mm/min. The test specimen consisted of strings, typically 0.38 mm wide, 0.51 mm deep and 4.57 cm long, generated in a single passage of the laser beam across the resin surface, and of handles for convenient fixing with chucking heads. The stress-strain curves exhibited two approximately linear parts corresponding to elastic and plastic deformation of the specimen. Tensile moduli were determined from the initial slopes of the curves taking into account the cross-sectional profile of the samples.

Example 1:

49 grams of a diacrylate ester of bisphenol A type epoxy resin with a viscosity of 2300 mPas at 65 °C and a theoretical functionality of 2 was mixed at 40 °C with 25 grams of ethoxylated bisphenol A dimethacrylate ester, 12 grams of trimethylolpropane trimethacrylate, 5 grams of 1-vinyl-2-pyrrolidinone, 5 grams of glycidyl-methacrylate and 4 grams of 1-hydroxycyclohexyl-phenylketone. The resulting clear mixture had a viscosity of 1760 mPas at 30 °C. The cure factor of a test part built with individual layers of 0.305 mm thickness using a HeCd laser was 1.11. The tensile modulus of the laser cured material (green strength) was 50 $N/mm^2$.

Example 2:

In the mixture of example 1 glycidylmethacrylate was replaced by dicyclopentenyl acrylate. Otherwise the composition remained unchanged. A similarly prepared test part had a tensile modulus in the green state of 91N/mm$^2$ with an elongation at break of 10.4 %. Curl factor at a cure depth of 0.018" was 1.18.

Examples 3 and 4:

A mixture of 50 wt% Chemlink® 3000 ex Sartomer Company (a bisphenol-A-diglycidyl-diacrylate) was mixed with 24 wt% SR 348 (Sartomer, an ethoxylated bisphenol-A-dimethacrylate), 11 wt% SR 350 (Sartomer, trimethylolpropane-trimethacrylate), 11 wt% 1-vinyl-pyrrolidinone and 4 wt% 1-hydroxycyclohexyl-phenylketone. The viscosity of the formulation was 1600 mPas at 30 °C and HeCd exposure yielded test parts with a curl factor of 1.27 at 0.305 mm cure depth and a tensile modulus of 50 N/mm$^2$. When 50 % of the 1-vinyl-2-pyrrolidinone was replaced by phenoxyethylacrylate the viscosity increased to 2100 mPas, curl factor dropped to 1.17 at 0.305 mm cure depth and the green tensile modulus strongly increased to 94 N/mm$^2$. This example visualizes the beneficial effect of bulky substituents on monofunctional monomers on curl as well as on green strength provided the reactivity lies in an acceptable range. The photosensitivity remained unchanged.

Example 5:

A formulation as in example 3 was prepared but instead of 1-hydroxycyclohexyl-phenylketon an equal amount of phenyl-(2-hydroxyisopropyl)ketone was used. The green strength dropped from 59 N/mm$^2$ to 37 N/mm$^2$ for this formulation.

Example 6-32:

These examples were tested along the same lines as the foregoing examples 1-5. Compositions and results are listed in tables 1 and 2.

<u>Table 1</u>: Composition of examples 6-30 in p.b.w.

| Ex. | Monomer | | | | | | | | | | | | |
|---|---|---|---|---|---|---|---|---|---|---|---|---|---|
| | A | B | C | D | E | F | G | H | I | J | K | L | M |
| 6 | 49.0 | 25.0 | - | - | 12.0 | - | - | 5.0 | 5.0 | - | 4.0 | - | |
| 7 | 46.0 | - | - | 23.1 | - | 16.8 | - | 4.9 | - | 5.2 | 4.0 | - | |
| 8 | 46.0 | - | 23.1 | - | - | 16.8 | - | 4.9 | - | 5.2 | 4.0 | - | |
| 9 | 46.5 | 23.3 | - | - | - | 17.0 | - | 5.0 | - | 5.2 | 3.0 | - | |
| 10 | 49.0* | 25.0 | - | - | - | - | 12.0 | 5.0 | - | 5.0 | 4.0 | - | |
| 11 | 49.0* | 25.0 | - | - | - | - | 12.0 | 10.0 | - | - | 4.0 | - | |
| 12 | 46.3* | 23.1 | - | - | - | 16.8 | - | 4.8 | - | 5.0 | 4.0 | - | |
| 13 | 50.0 | 25.0 | - | - | 12.0 | - | - | 11.0 | - | - | - | 2.0 | |
| 14 | 50.0* | 25.0 | - | - | 12.0 | - | - | 5.5 | - | 5.5 | - | 2.0 | |
| 15 | 48.37 | 22.0 | - | - | 11.25 | - | - | 3.3 | - | 10.25 | 4.8 | - | |
| 16 | 49.7 | 22.3 | - | - | 12.5 | - | - | 6.6 | - | 4.06 | 4.86 | - | |
| 17 | 36.62* | 33.93 | - | - | 11.58 | - | - | 10.61 | - | - | 7.26 | - | |
| 18 | 39.6* | 32.6 | - | - | 12.4 | - | - | 5.5 | - | 4.3 | 5.6 | - | |
| 19 | 42.9 | 34.9 | - | - | 7.1 | - | - | 5.4 | - | 5.4 | 4.3 | - | |
| 20 | 49.0 | 25.0 | - | - | 12.0 | - | - | 5.0 | - | 5.0 | 4.0 | - | |
| 21 | 49.0 | 25.0 | - | - | 12.0 | - | - | 5.0 | - | 5.0 | - | 4.0 | |
| 22 | 45.1 | 31.9 | - | - | 6.0 | - | - | 5.2 | - | 7.1 | 4.7 | - | |
| 23 | 53.6 | 20.0 | - | - | 7.2 | - | - | 7.3 | - | 7.0 | 4.9 | - | |
| 24 | 36.62 | 33.93 | - | - | 11.58 | - | - | 10.61 | - | - | 7.26 | - | |
| 25 | 39.6 | 32.6 | - | - | 12.4 | - | - | 5.5 | - | 4.3 | 5.6 | - | |
| 26 | 34.0 | 30.0 | - | - | 17.0 | - | - | 7.0 | - | 7.0 | 5.0 | - | |
| 27 | 52.0 | 20.0 | - | - | 17.0 | - | - | 3.0 | - | 3.0 | 5.0 | - | |
| 28 | 44.0 | 30.0 | - | - | 7.0 | - | - | 7.0 | - | 7.0 | 5.0 | - | |
| 29 | 46.62 | 25.0 | - | - | 12.0 | - | - | 5.0 | - | 5.0 | 6.38 | - | |
| 30 | 42.62 | 28.54 | - | - | 12.10 | - | - | 6.92 | - | 4.5 | 5.48 | - | |
| 31 | 48.0 | - | 25.0 | - | - | - | - | 5.0 | - | 5.0 | 5.0 | - | 12.0 |
| 32 | 49.0 | - | 25.0 | - | - | - | - | 5.0 | - | 5.0 | 4.0 | - | 12.0 |

A = Diacrylate of Ex. 1 (* = C 3000)
C 3000: bisphenol-A-diglycidyl-diacrylate (ex Sartomer Comp.)
B = SR 348: ethoxylated bisphenol-A-dimethacrylate (ex Sartomer Comp.)
C = SR 349: ethoxylated bisphenol-A-diacrylate (ex Sartomer Comp.)
D = SR 252: polyethylenglycol (600)-dimethacrylate (ex Sartomer Comp.)
E = SR 350: trimethylolpropane-trimethacrylate (ex Sartomer Comp.)
F = SR 399: dipentaerythritolpentaacrylate (ex Sartomer Comp.)
G = GPTA: Glycerylpropoxytriacrylate,
H = VP : 1-Vinyl-2-pyrrolidinone,
I = TCDMA: Dihydro-cyclopentadienylmethacrylate
J = SR 339: 2-phenoxyethylacrylate (ex Sartomer Comp.)
K = 1-hydroxycyclohexylphenylketone
L = benzil-dimethylketal
M = trimethylolpropane-triacrylate (ex Sartomer Comp.)

Table 2

| Properties of formulations according to examples 6-30 | | | |
|---|---|---|---|
| Example | Viscosity at 30 °C, mPas | Curl factor at 0.305 mm cure depth | Green strength tensile modulus N/mm$^2$ |
| 6 | 2690 | 1.04 | 60 |
| 7 | 1390 | 1.09 | 17 |
| 8 | 3970 | 1.00 | 450 |
| 9 | 4000 | 1.13 | 96 |
| 10 | 3170 | 1.09 | 92 |
| 11 | 4900 | 1.06 | 187 |
| 12 | 4300 | 1.06 | 184 |
| 13 | 1600 | 1.52 | 22 |
| 14 | 2400 | 1.42 | 46 |
| 15 | 1610 | n.a. | 82 |
| 16 | 1690 | 1.23 | 167 |
| 17 | 860 | 1.04 | 101 |
| 18 | 1200 | 1.16 | 93 |
| 19 | 1260 | 1.17 | 41 |
| 20 | 2160 | 1.15 | 103 |
| 21 | 2200 | 1.23 | |
| 22 | 1440 | 1.09 | 67 |
| 23 | 1700 | 1.17 | 81 |
| 24 | 700 | 1.37 | 33 |
| 25 | 985 | 1.15 | 70 |
| 26 | 500 | 1.25 | 33 |
| 27 | 3260 | 1.17 | 192 |
| 28 | 1200 | 1.15 | 85 |
| 29 | 1770 | 1.09 | 230 |
| 30 | 1140 | 1.14 | 123 |
| 31 | 1920 | 1.28 | |
| 32 | 2050 | 1.10 | |

## Claims

1. Liquid resin compositions which are photosensitive and have a viscosity in the range of 500 to 5000 mPas at 30 °C comprising
   (i) at least one monomeric or oligomeric diacrylate or dimethacrylate having a viscosity of more than 500 mPas at 25 °C
   (ii) at least one tri-, tetra- or pentaacrylate or -methacrylate selected from the group consisting of the compounds of the formulae I, II and III

   $R^1$-$CH_2$-C$(CH_2$-$R^2)_3$ (I)

   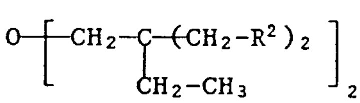
   (II)

   $R^2$-CH$(CH_2$-$R^2)_2$ (III),

   wherein $R^1$ denotes hydrogen, methyl, hydroxy or a group

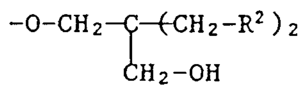 (IV)

and $R^2$ is a group

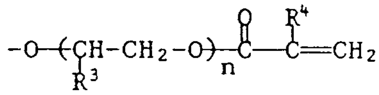 (V)

wherein n is an integer 0, 1, 2 or 3, $R^3$ and $R^4$ are each independently of the other hydrogen or methyl,
(iii) at least one unsaturated monofunctional monomeric compound of the formula VI

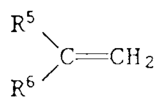 (VI),

wherein $R^5$ denotes hydrogen or methyl and $R^6$ is a group of the formula VII

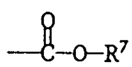 (VII),

$R^7$ being tetrahydrofurfuryl, cyclohexyl, 2-phenoxyethyl, benzyl, isobornyl, glycidyl, dicyclopentenyl, morpholinoethyl, dimethylaminoethyl, diethylaminoethyl or a $C_1$-$C_{20}$ linear or branched aliphatic residue, or - if $R^5$ is hydrogen $R^6$ denotes additionally pyrrolidinon-2-yl, imidazolyl, carbazolyl, anthracenyl, phenyl, $C_5$-$C_8$ cycloalkyl, naphthenyl, 2-norbornyl, pyridyl, N-caprolactamyl or toluyl and
(iv) a photo-polymerization initiator for (i), (ii) and/or (iii).

**2.** Compositions according to claim 1 containing as component (i) at least one acrylic or methacrylic diester of the general formula VIII

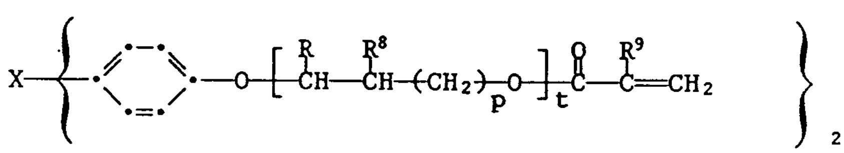 (VIII),

wherein p is 0 or 1 and t is 0 or 1 and if p is 0, t can also be 2 or 3, X denotes -O-, -S-, $-SO_2-$ or $-C(R^{10})(R^{11})-$, $R^{10}$ and $R^{11}$ each being independently of the other hydrogen, $-CF_3$ or methyl and R denotes hydrogen if p is 1 and hydrogen or methyl if p is 0, and $R^8$ denotes hydroxy if p is 1 and hydrogen if p is 0, and $R^9$ is hydrogen or methyl.

**3.** Compositions according to claim 2, characterized in that in formula VIII p denotes 1.

**4.** Compositions according to claim 3, characterized in that in formula VIII X is $-C(CH_3)_2-$.

**5.** Compositions according to claim 2 containing as component (i) a mixture of compounds of the formula VIII comprising at least one compound wherein p is 1 and at least one compound wherein p is 0.

**6.** Compositions according to claim 1 containing the component (i) in a total amount of about 10 to about 80 weight percent of the total composition.

7. Compositions according to claim 3 containing the compound of formula VIII in a total amount of 30 to about 60 weight percent based on the total composition.

8. Composition according to claim 1 containing as component (ii) at least one triacrylate or -methacrylate of the formula I wherein $R^1$ is methyl or a group of the formula IV and $R^2$ denotes a group of the formula V wherein n is 0.

9. Compositions according to claim 1 containing as component (ii) trimethylolpropanetrimethacrylate or dipentaerythritolpentaacrylate.

10. Composition according to claim 1 containing the component (ii) in a total amount of about 5 to about 25 weight percent based on the total composition.

11. Composition according to claim 1, containing as component (iii) a compound of the formula VI wherein $R^5$ is hydrogen and $R^6$ is a group of the formula VII, pyrrolidon-2-yl or N-caprolactamyl.

12. Compositions according to claim 11, containing as component (iii) 1-vinylpyrrolidone, isobornylacrylate and/or phenoxyethylacrylate.

13. Compositions according to claim 1, containing the component (iii) in a total amount of about 1 to about 25 weight percent based on the total composition.

14. Compositions according to claim 1, containing as component (iv) an acetophenone, an 1-hydroxyphenylketone and/or benzilketal.

15. Compositions according to claim 1, containing component (iv) in a total amount of about 0.1 to about 10 weight percent based on the total composition.

16. Compositions according to claim 1 with a viscosity in the range of 1000 to 4000 mPas at 30 °C.

17. A process for polymerizing the compositions according to claim 1 comprising subjecting said compositions to actinic radiation.

18. A method of generating three-dimensional objects from a fluid medium capable of altering its physical state when subjected to prescribed radiation, said method comprising:
   - containing as fluid medium a body of a composition according to claim 1;
   - irradiating a designated surface of said composition with a prescribed pattern to provide a thin cross-sectional lamina at said designated surface; and
   - repeatedly forming a series of such laminae in succession to build the desired three-dimensional object from successive adjacent laminae which together define said object.

19. A method according to claim 18 wherein the radiation source is a UV-laser beam.

20. A method according to claim 19 wherein the laser beam is computer controlled.

**Patentansprüche**

1. Flüssige Harzzusammensetzungen, die photosensitiv sind und eine Viskosität im Bereich von 500 bis 5000 mPas bei 30 °C besitzen, umfassend
   (i) zumindest ein monomeres oder digomeres Diacrylat oder Dimethacrylat mit einer Viskosität von mehr als 500 mPas bei 25 °C,
   (ii) zumindest ein Tri-, Tetra- oder Pentacrylat oder -methacrylat, ausgewählt unter den Verbindungen der Formeln I, II und III

$$R^1\text{-}CH_2\text{-}C\text{+}CH_2\text{-}R^2)_3 \qquad (I)$$

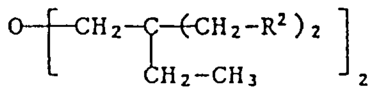 (II)

$R^2\text{-}CH(CH_2\text{-}R^2)_2$ (III),

worin $R^1$ für Wasserstoff, Methyl, Hydroxy oder eine Gruppe

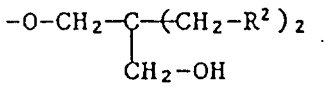 (IV)

steht und $R^2$ eine Gruppe

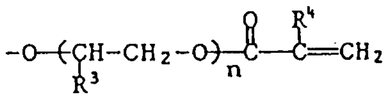 (V)

ist, worin n die ganze Zahl 0, 1, 2 oder 3 ist, $R^3$ und $R^4$ jeweils unabhängig Wasserstoff oder Methyl bedeuten,
(ii) zumindest eine ungesättigte, monofunktionelle monomere Verbindung der Formel VI

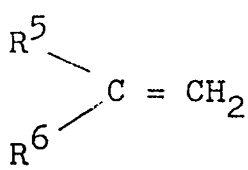 (VI)

worin $R^5$ für Wasserstoff oder Methyl steht und $R^6$ eine Gruppe der Formel VII

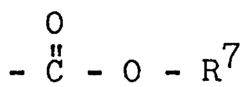 (VII)

ist, wobei $R^7$ Tetrahydrofurfuryl, Cyclohexyl, 2-Phenoxyethyl, Benzyl, Isobornyl, Glycidyl, Dicyclopentenyl, Morpholinoethyl, Dimethylaminoethyl, Diethylaminoethyl oder einen linearen oder verzweigten aliphatischen $C_{1-20}$-Rest bedeutet, oder - wenn $R^5$ für Wasserstoff steht, $R^6$ zusätzlich Pyrrolidinon-2-yl, Imidazolyl, Carbazolyl, Anthracenyl, Phenyl, $C_{5-8}$-Cycloalkyl, Naphthenyl, 2-Norbornyl, Pyridyl, N-Caprolactamyl oder Toluyl bedeutet, und
(iv) einen Photo-Polymerisationsinitiator für (i), (ii) und/oder (iii).

**2.** Zusammensetzungen gemäß Anspruch 1, enthaltend als Komponente (i) zumindest einen acrylischen oder methacrylischen Diester der allgemeinen Formel VIII

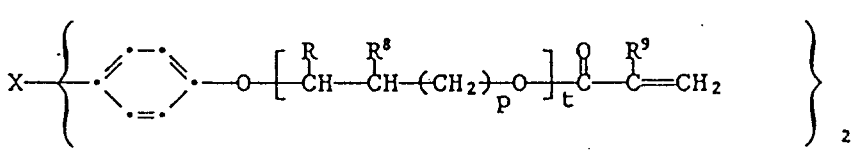 (VIII),

worin p für 0 oder 1 steht und t für 0 oder 1 steht, und wenn p für 0 steht, t auch 2 oder 3 sein kann, X für -O-, -S-, $-SO_2-$ oder $-C(R^{10})(R^{11})-$ steht, worin $R^{10}$ und $R^{11}$ jeweils unabhängig Wasserstoff, $-CF_3$ oder Methyl bedeuten und R Wasserstoff bedeutet, wenn p für 1 steht,und Wasserstoff oder Methyl

bedeutet, wenn p für 0 steht, und $R^8$ Hydroxy bedeutet, wenn p für 1 steht, und Wasserstoff bedeutet, wenn p für 0 steht, und $R^9$ für Wasserstoff oder Methyl steht.

**3.** Zusammensetzungen gemäß Anspruch 2, dadurch gekennzeichnet, daß in Formel VIII p für 1 steht.

**4.** Zusammensetzungen gemäß Anspruch 3, dadurch gekennzeichnet, daß in Formel VIII X für $-C(CH_3)_2-$ steht.

**5.** Zusammensetzungen gemäß Anspruch 2, enthaltend als Komponente (i) eine Mischung von Verbindungen der Formel VIII, umfassend zumindest eine Verbindung, worin p für 1 steht, und zumindest eine Verbindung, worin p für 0 steht.

**6.** Zusammensetzungen gemäß Anspruch 1, enthaltend die Komponente (i) in einer Gesamtmenge von etwa 10 bis etwa 80 Gew.% der Gesamtzusammensetzung.

**7.** Zusammensetzungen gemäß Anspruch 3, enthaltend die Verbindung der Formel VIII in einer Gesamtmenge von 30 bis etwa 60 Gew.%, basierend auf der Gesamtzusammensetzung.

**8.** Zusammensetzungen gemäß Anspruch 1, enthaltend als Komponente (ii) zumindest ein Triacrylat oder -methacrylat der Formel I, worin $R^1$ Methyl oder eine Gruppe der Formel IV bedeutet und $R^2$ eine Gruppe der Formel V darstellt, worin n für 0 steht.

**9.** Zusammensetzungen gemäß Anspruch 1, enthaltend als Komponente (ii) Trimethylolpropan-trimethacrylat oder Dipentaerythrit-pentaacrylat.

**10.** Zusammensetzungen gemäß Anspruch 1, enthaltend die Komponente (ii) in einer Gesamtmenge von etwa 5 bis etwa 25 Gew.%, basierend auf der Gesamtzusammensetzung.

**11.** Zusammensetzungen gemäß Anspruch 1, enthaltend als Komponente (iii) eine Verbindung der Formel VI, worin $R^5$ für Wasserstoff steht und $R^6$ eine Gruppe der Formel VII, Pyrrolidon-2-yl oder N-Caprolactamyl ist.

**12.** Zusammensetzungen gemäß Anspruch 11, enthaltend als Komponente (iii) 1-Vinylpyrrolidon, Isobornylacrylat und/oder Phenoxyethylacrylat.

**13.** Zusammensetzungen gemäß Anspruch 1, enthaltend die Komponente (iii) in einer Gesamtmenge von etwa 1 bis etwa 25 Gew.%, basierend auf der Gesamtzusammensetzung.

**14.** Zusammensetzungen gemäß Anspruch 1, enthaltend als Komponente (iv) ein Acetophenon, ein 1-Hydroxyphenylketon und/oder Benzilketal.

**15.** Zusammensetzungen gemäß Anspruch 1, enthaltend die Komponente (iv) in einer Gesamtmenge von etwa 0,1 bis etwa 10 Gew.%, basierend auf der Gesamtzusammensetzung.

**16.** Zusammensetzungen gemäß Anspruch 1 mit einer Viskosität im Bereich von 1000 bis 4000 mPas bei 30 °C.

**17.** Verfahren zur Polymerisation der Zusammensetzungen gemäß Anspruch 1, bei dem man diese Zusammensetzungen einer aktinischen Strahlung aussetzt.

**18.** Verfahren zur Erzeugung von dreidimensionalen Gegenständen aus einem fluiden Medium, das in der Lage ist, seinen physikalischen Zustand zu ändern, wenn es einer vorgegebenen Bestrahlung ausgesetzt wird, umfassend

das Einsetzen als fluides Medium eines Körpers aus einer Zusammensetzung gemäß Anspruch 1;

die Bestrahlung einer vorgesehenen Fläche der Zusammensetzung mit einem vorgegebenen Muster, um eine dünne Querschnittsschicht an der vorgegebenen Fläche zu erzeugen; und

die wiederholte Bildung einer Reihe derartiger Schichten in Folge, um den gewünschten dreidimensionalen Gegenstand aus aufeinanderfolgenden, benachbarten Schichten, die zusammen den Gegenstand definieren, aufzubauen.

**19.** Verfahren gemäß Anspruch 18, worin die Strahlungsquelle ein UV-Laserstrahl ist.

**20.** Verfahren gemäß Anspruch 19, worin der Laserstrahl computerkontrolliert wird.

**Revendications**

**1.** Compositions de résine liquide qui sont photosensibles et ont une viscosité comprise dans l'intervalle de 500 à 5000 mPa.s à 30 °C, comprenant

(i) au moins un diacrylate ou diméthacrylate monomère ou oligomère ayant une viscosité supérieure à 500 mPa.s à 25 °C

(ii) au moins un tri-, tétra- ou penta-acrylate ou -méthacrylate choisi dans le groupe formé par les composés des formules I, II et III

$R^1\text{-}CH_2\text{-}C(CH_2\text{-}R^2)_3$ (I)

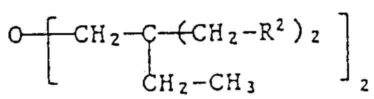

(II)

$R^2\text{-}CH(CH_2\text{-}R^2)_2$ (III),

où $R^1$ représente l'hydrogène, un groupe méthyle, un groupe hydroxyle ou un groupe

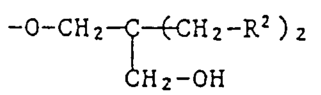

(IV)

et $R^2$ est un groupe

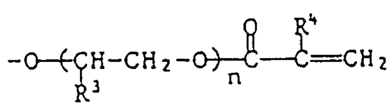

(V)

où n est le nombre entier 0, 1, 2 ou 3, et $R^3$ et $R^4$ sont chacun, indépendamment de l'autre, l'hydrogène ou un groupe méthyle,

(iii) au moins un composé monomère monofonctionnel insaturé de formule VI

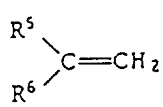

(VI),

où $R^5$ représente l'hydrogène ou un groupe méthyle et $R^6$ est un groupe de formule VII

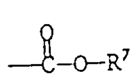

(VII),

$R^7$ étant un groupe tétrahydrofurfuryle, cyclohexyle, 2-phénoxyéthyle, benzyle, isobornyle, glycidyle, dicyclopentényle, morpholinoéthyle, diméthylaminoéthyle, diéthylaminoéthyle ou un résidu aliphatique linéaire ou ramifié en $C_1$-$C_{20}$, ou, si $R^5$ est l'hydrogène, $R^6$ représente de plus un groupe pyrrolidinone-2-yle, imidazolyle, carbazolyle, anthracényle, phényle, cycloalkyle en $C_5$-$C_8$, naphthényle, 2-norbornyle, pyridyle, N-caprolactamyle ou toluyle, et

(iv) un initiateur de photopolymérisation pour (i), (ii) et/ou (iii)

**2.** Compositions selon la revendication 1, contenant comme composant (i) au moins un diester acrylique ou méthacrylique de formule générale VIII

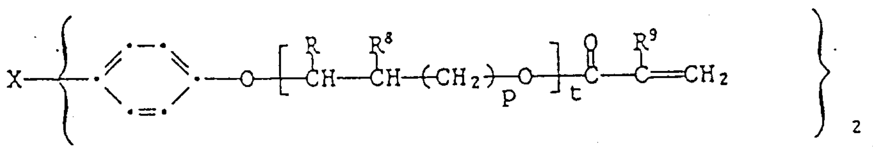

(VIII),

où p est 0 ou 1 et t est 0 ou 1 et, si p est 0, t peut également être 2 ou 3, X représente -O-, -S-, $-SO_2-$ ou $-C(R^{10})(R^{11})-$, $R^{10}$ et $R^{11}$ étant chacun, indépendamment de l'autre, l'hydrogène, $-CF_3$ ou un groupe méthyle, et R représente l'hydrogène si p est 1 et l'hydrogène ou un groupe méthyle si p est 0, et $R^8$ représente un groupe hydroxyle si p est 1 et l'hydrogène si p est 0, et $R^9$ est l'hydrogène ou un groupe méthyle.

**3.** Compositions selon la revendication 2, caractérisées en ce que, dans la formule VIII, p est 1.

**4.** Compositions selon la revendication 3, caractérisées en ce que, dans la formule VIII, X est $-C(CH_3)_2-$.

**5.** Compositions selon la revendication 2, contenant, comme composant (i), un mélange de composés de formule VIII comprenant au moins un composé où p est 1 et au moins un composé où p est 0.

**6.** Compositions selon la revendication 1, contenant le composant (i) en une quantité totale d'environ 10 à environ 80 pour cent en poids de la composition totale.

**7.** Compositions selon la revendication 3, contenant le composé de formule VIII en une quantité totale de 30 à environ 60 pour cent en poids de la composition totale.

**8.** Compositions selon la revendication 1, contenant, comme composant (ii), au moins un triacrylate ou triméthacrylate de formule I où $R^1$ est un groupe méthyle ou un groupe de formule IV et $R^2$ est un groupe de formule V où n est 0.

**9.** Compositions selon la revendication 1, contenant, comme composant (ii), le triméthacrylate de triméthylolpropane ou le pentaacrylate de dipentaérythritol.

**10.** Compositions selon la revendication 1, contenant le composant (ii) en une quantité totale d'environ 5 à environ 25 pour cent en poids de la composition totale.

**11.** Composition selon la revendication 1, contenant, comme composant (iii), un composé de formule VI où $R^5$ est l'hydrogène et $R^6$ est un groupe de formule VII, pyrrolidone-2-yle ou N-caprolactamyle.

**12.** Compositions selon la revendication 11, contenant, comme composant (iii), la 1-vinylpyrrolidone, l'acrylate d'isobornyle et/ou l'acrylate de phénoxyéthyle.

**13.** Compositions selon la revendication 1, contenant le composant (iii) en une quantité totale d'environ 1 à environ 25 pour cent en poids de la composition totale.

**14.** Compositions selon la revendication 1, contenant, comme composant (iv), une acétophénone, une 1-hydroxyphénylcétone et/ou un cétal de benzile.

**15.** Compositions selon la revendication 1, contenant le composant (iv) en une quantité totale d'environ 0,1 à environ 10 pour cent en poids de la composition totale.

**16.** Compositions selon la revendication 1, ayant une viscosité comprise dans l'intervalle de 1000 à 4000 mPa.s à 30 °C.

**17.** Procédé pour polymériser les compositions selon la revendication 1, consistant à soumettre lesdites compositions à un rayonnement actinique.

**18.** Procédé de production d'objets tridimensionnels à partir d'un milieu fluide capable de modifier son état physique lorsqu'il est soumis à un rayonnement prédéterminé, ledit procédé consistant à :
- placer dans un récipient une masse d'une composition selon la revendication 1 comme milieu fluide ;
- irradier une surface désignée de ladite composition selon une configuration prédéterminée pour former une couche mince de section transversale au niveau de ladite surface désignée ; et
- former par réitération une série de telles couches en succession pour édifier l'objet tridimensionnel désiré à partir de couches adjacentes successives qui, ensemble, définissent ledit objet.

**19.** Procédé selon la revendication 18, dans lequel la source de rayonnement est un faisceau de laser UV.

**20.** Procédé selon la revendication 19, dans lequel le faisceau laser est piloté par ordinateur.